# FASCICULE DE BREVET EUROPEEN

(11) **EP 3 629 347 B1**
(45) Date de publication et mention de la délivrance du brevet: **17.02.2021**
(21) Numéro de dépôt: 19187480.9
(22) Date de dépôt: 22.07.2019
(51) Int. Cl.: H01F 27/26, G01R 15/18, H01F 27/28, H01F 38/30

(54) **TRANSFORMATEUR DE COURANT ELECTRIQUE ET APPAREIL DE MESURE DE COURANT**
STROMTRANSFORMATOR UND STROMMESSGERÄT
ELECTRIC CURRENT TRANSFORMER AND CURRENT MEASURING DEVICE

(30) Priorité: 27.09.2018 FR 1858838
(43) Date de publication de la demande: 01.04.2020
(73) Titulaire: Schneider Electric Industries SAS, 92500 Rueil Malmaison (FR)
(72) Inventeur: URANKAR, Lionel, 38050 GRENOBLE (FR); AMBLARD, Jean-Yves, 38050 GRENOBLE (FR); DU PELOUX DE SAINT ROMAIN, Bertrand, 38050 GRENOBLE (FR)
(74) Mandataire: Tripodi, Paul

(56) Documents cités:
- FR-A1- 2 701 591
- FR-B1- 2 920 881

## Description

### DOMAINE TECHNIQUE

La présente invention est relative à un transformateur de courant destiné à la mesure d'un courant électrique circulant dans un conducteur de courant. Elle s'applique plus particulièrement à la mesure des courants alternatifs, en milieu industriel.

L'invention concerne également un appareil de mesure de l'intensité d'un courant électrique ou de mesure de puissance ou d'énergie électrique.

### ETAT DE LA TECHNIQUE

Un transformateur de courant est fréquemment utilisé, dans un appareil de mesure du courant, de puissance ou d'énergie électrique, pour fournir un signal représentatif d'un courant électrique à mesurer dans une installation électrique. Le transformateur de courant a l'avantage d'offrir une isolation galvanique entre une ligne de courant dans laquelle circule le courant à mesurer et le/les circuits de mesure du signal fournit par le transformateur de courant. Cet avantage est utile pour la mesure de courant dans une installation électrique de tension 400 Volt, par exemple. La conception de tels transformateurs de courant est simple et éprouvée mais des contraintes nouvelles apparaissent, liées en particulier à la demande de maîtrise de la consommation d'énergie :
- le transformateur de courant doit fournir un signal d'amplitude suffisante, de grande précision pour une large gamme d'amplitude du courant à mesurer,
- le transformateur doit être peu sensible à la diaphonie et aux champs électromagnétiques extérieurs,
- le transformateur doit être compact pour être intégré dans un appareil de mesure de faible volume ou pour être installé sur un jeu de barre dont l'espacement entre les conducteurs de courant est normalisé, par exemple, à 18, 25 ou 27 mm,
- le prix de revient du transformateur doit être faible pour maîtriser le coût engendré par une multiplication des points de mesure dans l'installation électrique, et
- le transformateur de courant doit pouvoir être réalisé industriellement en grande série en garantissant la précision de mesure demandée sans nécessiter d'opération de calibrage.

Un transformateur de courant comportant une bobine enroulée sur un circuit magnétique fournit un signal précis dans une plage de variations excluant les très faibles courants et les très forts courants à mesurer. Un transformateur de Rogowski, ne comportant pas de circuit magnétique, offre une dynamique de mesure très étendue mais un niveau de signal plus faible. Pour concilier l'ensemble des contraintes, un compromis consiste à construire un transformateur de courant comportant un ou plusieurs noyaux magnétiques comportant un ou plusieurs entrefers dans lesquels sont disposés des enroulements de mesure. Par exemple, la demande de brevet FR 2 891 946 A1 décrit un dispositif de mesure ouvrant, comportant un bobinage enroulé sur une armature amagnétique et disposé dans l'entrefer d'une culasse magnétique en forme de « U ». La demande de brevet FR 2 977 323 A1 décrit un dispositif de mesure comportant un noyau magnétique formé de deux pièces en forme de « I » formant à leur extrémité deux entrefers dans lesquels sont disposées deux bobines secondaires de mesure.

L'emploi d'un circuit imprimé pour réaliser des bobines de mesure est décrit dans la demande de brevet WO 01/57 543 A1 : une première variante de capteur de courant de Rogowski comporte deux bobines circulaires, chaque bobine étant disposée sur une carte de circuit imprimé. Une autre variante montre un capteur de forme rectangulaire dont les côtés sont formés par des bobines rectilignes et les angles sont formés de pièces de blindage magnétique. Le brevet FR 2 920 881 B1 décrit un dispositif de mesure de l'intensité d'un courant électrique comportant un circuit magnétique ouvert et délimite un entrefer large dans lequel est logé une bobine électrique, l'entrefer ayant une largeur au moins supérieure au double de la section du circuit magnétique

Le document FR2701591 divulgue en outre un transformateur de courant ayant deux bobines dont l'axe d'extension est perpendiculaire au conducteur constituant le primaire du transformateur ainsi que deux éléments magnétiques possédant des moyens de positionnement et de montage.

Les solutions proposées dans les documents de l'art antérieur permettent de mesurer des courants électriques avec une excellente précision lorsque le capteur a une forme circulaire. Cependant, lesdites solutions sont insuffisantes pour mesurer des courants électriques avec une précision meilleure que 0,5 % lorsque les capteurs ont une forme polygonale ajustée pour être implantés dans un équipement triphasé. En effet, chaque capteur est influencé par le champ magnétique généré par les courants circulant dans les phases adjacentes et les discontinuités géométriques introduites par les angles accentuent cette influence négative. La présente invention vise donc à remédier à ces inconvénients.

### EXPOSE DE L'INVENTION

Pour cela, l'invention concerne un transformateur de courant comportant :
- une première bobine et une deuxième bobine, réalisées au moyen d'un premier circuit imprimé de forme sensiblement parallélépipédique, comportant une première face supérieure, une première face inférieure, un premier côté, un deuxième côté, le deuxième côté étant opposé au premier côté, un troisième côté, un quatrième côté, le quatrième côté étant opposé au troisième côté, la première bobine étant formée de premières spires bobinées selon un premier axe de bobinage sensiblement perpendiculaire au troisième et au quatrième côtés, la deuxième bobine étant formée de secondes spires bobinées selon un second axe de bobinage sensiblement perpendiculaire au troisième et au quatrième côtés, le premier circuit imprimé comportant une première ouverture dans les premières faces supérieure et inférieure pour former un passage traversant à une ligne de courant, ladite ligne de courant formant un circuit primaire du transformateur de courant, la première bobine et la deuxième bobines étant disposées de part et d'autre de la première ouverture et formant un circuit secondaire, et
- une première pièce magnétique de forme allongée comportant une première face de référence et au moins une seconde pièce magnétique de forme allongée comportant une seconde face de référence,
le transformateur de courant 1 étant tel que :
- le premier circuit imprimé comportant un premier moyen de positionnement, disposé à proximité du troisième côté, et un second moyen de positionnement disposé à proximité du quatrième côté,
- la première pièce magnétique comportant un premier moyen de maintien,
- la seconde pièce magnétique comportant un second moyen de maintien,
le premier moyen de positionnement est agencé pour s'assembler avec le premier moyen de maintien pour maintenir la première face de référence à une distance prédéterminée en vis-à-vis du troisième côté, et le second moyen de positionnement est agencé pour s'assembler avec le second moyen de maintien pour maintenir la seconde face de référence à une distance prédéterminée en vis-à-vis du cinquième côté.

Avantageusement :
- le premier moyen de positionnement et le second moyen de positionnement sont des trous percés dans le premier circuit imprimé,
- le premier moyen de maintien est un ergot agencé pour être inséré dans le premier moyen de positionnement, et
- le second moyen de maintien est un ergot agencé pour être inséré dans le second moyen de positionnement.

Préférentiellement :
- le premier moyen de positionnement est disposé dans une première protubérance formée sur le troisième côté du premier circuit imprimé,
- le second moyen de positionnement est disposé dans une deuxième protubérance formée sur le quatrième côté dudit premier circuit imprimé,
- le premier moyen de maintien est formé par une découpe de la première pièce magnétique, et
- le second moyen de maintien est formé par une découpe de la seconde pièce magnétique.

Avantageusement, la première bobine et la deuxième bobine sont formées de spires bobinées avec un pas de bobinage constant.

Préférentiellement, le pas de bobinage est compris entre 50 et 700 microns.

Avantageusement, la première face de référence et la seconde face de référence dépassent la première face supérieure et la première face inférieure d'une distance supérieure à un pas de bobinage.

Avantageusement, chaque spire étant réalisée dans l'épaisseur du premier circuit imprimé et comportant un premier tronçon conducteur sur la première face supérieure du premier circuit imprimé et un second tronçon conducteur sur la première face inférieure dudit premier circuit imprimé, les premiers tronçons conducteurs des spires de la première bobine sont symétriques, par rapport au centre de la première ouverture, des premiers tronçons conducteurs des spires de la deuxième bobine et les seconds tronçons conducteurs des spires de la première bobine sont symétriques, par rapport au centre de la première ouverture, des seconds tronçons conducteurs des spires de la deuxième bobine.

De préférence, la première bobine comportant une première spire latérale à une première extrémité en regard de la première face de référence, et une deuxième spire latérale à une deuxième extrémité en regard de la seconde face de référence, et la deuxième bobine comportant une troisième spire latérale à une troisième extrémité en regard de la première face de référence, et une quatrième spire latérale à une quatrième extrémité en regard de la seconde face de référence, la première bobine et la deuxième bobine sont disposées sur le premier circuit imprimé de telle manière que :
- la distance entre la première spire latérale de la première bobine et la première face de référence est sensiblement égale à la moitié du pas de bobinage,
- la distance entre la première spire latérale de la deuxième bobine et la première face de référence est sensiblement égale à la moitié du pas de bobinage,
- la distance entre la seconde spire latérale de la première bobine et la seconde face de référence est sensiblement égale à la moitié du pas de bobinage, et
- la distance entre la seconde spire latérale de la deuxième bobine et la seconde face de référence est sensiblement égale à la moitié du pas de bobinage.

Avantageusement, les extrémités d'au moins un des premiers ou seconds tronçons respectivement de la première spire latérale et de la seconde spire latérale de la première bobine et de la deuxième bobine sont recourbées pour former un C dont les extrémités s'éloignent respectivement de la première face de référence et de la seconde face de référence.

Préférentiellement, la première et la deuxième bobine sont connectées électriquement en série, la première spire latérale de la première bobine étant reliée à la première spire latérale de la deuxième bobine et la seconde spire latérale de la première bobine étant reliée à la seconde spire latérale de la deuxième bobine.

Avantageusement, la première bobine est composée de :
- une première demi-bobine comprenant un premier point de connexion électrique, et
- une deuxième demi-bobine comprenant un second point de connexion électrique, le premier et le second point de connexion étant localisés sensiblement au milieu du premier côté.

Préférentiellement, le transformateur de courant comporte une troisième bobine et une quatrième bobine réalisées au moyen d'un second circuit imprimé de forme sensiblement parallélépipédique, comportant une seconde face supérieure, une seconde face inférieure, un cinquième côté, un sixième côté, le sixième côtés étant opposé au cinquième côté, un septième côté, un huitième côté, le huitième côté étant opposé au septième côté, la troisième et la quatrième bobines étant bobinées respectivement selon des axes parallèles au premier et au second axe de bobinage, le second circuit imprimé comportant une seconde ouverture dans les deux secondes faces pour former un passage traversant au conducteur électrique, la troisième bobine et la quatrième bobine étant disposées de part et d'autre de la seconde ouverture.

Avantageusement, le second circuit imprimé comporte :
- un troisième moyen de positionnement agencé pour s'assembler avec le premier moyen de maintien pour maintenir la première face de référence à une distance prédéterminée du septième côté, et
- un quatrième moyen de positionnement agencé pour s'assembler avec le second moyen de maintien pour maintenir la seconde face de référence à une distance prédéterminée du huitième côté.

Préférentiellement, la troisième bobine et la quatrième bobine étant formées de spires réalisées dans l'épaisseur du second circuit imprimé :
- la troisième bobine est bobinée selon un sens inverse par rapport au sens de bobinage de la première bobine, et
- la quatrième bobine est bobinée selon un sens inverse par rapport au sens de bobinage de la deuxième bobine.

Préférentiellement, la troisième bobine comporte :
- une troisième demi-bobine comprenant un troisième point de connexion électrique, et
- une quatrième demi-bobine comprenant un quatrième point de connexion électrique,
le troisième point de connexion électrique et le quatrième point de connexion électrique étant localisés sensiblement au milieu du cinquième côté.

De préférence, le premier circuit imprimé ou le second circuit imprimé comporte une troisième protubérance pour implanter :
- un ou plusieurs circuits de mesure pour traiter des signaux délivrés par les première, deuxième, troisième et quatrième bobines et fournir un signal de mesure représentatif du courant circulant dans la ligne de courant,
- des connexions électriques pour transmettre le signal de mesure à un appareil de mesure.

L'invention a également pour objet un appareil de mesure du courant circulant dans une ligne de courant 2 d'une installation électrique, ledit appareil comportant :
- un transformateur de courant tel que décrit précédemment, comportant une première ouverture et une seconde ouverture dans lesquelles passe une ligne de courant, ledit transformateur de courant fournissant :
   - un premier signal de mesure représentatif du courant circulant dans la ligne de courant passant dans la première ouverture, et
   - un second signal de mesure représentatif du courant circulant dans la ligne de courant passant dans la seconde ouverture du dispositif de mesure du courant, et
- un circuit de mesure, connecté au transformateur de courant, connecté au transformateur de courant pour recevoir le premier signal de mesure et le second signal de mesure, ledit circuit de mesure fournissant une mesure de l'amplitude du courant circulant dans la ligne de courant, ladite mesure étant issue d'une mesure du premier signal de mesure et du second signal de mesure,
- un circuit d'interface relié au circuit de mesure pour afficher la mesure du signal de mesure ou transmettre ladite mesure, et
- un circuit d'alimentation pour alimenter le circuit de mesure et le circuit d'interface.

### BREVE DESCRIPTION DES DESSINS

D'autres avantages et caractéristiques ressortiront plus clairement de la description qui va suivre, de modes particuliers de réalisation de l'invention, donnés à titre d'exemples non limitatifs, et représentés aux dessins annexés sur lesquels :
- la figure 1 est une vue éclatée d'un premier mode de réalisation d'un transformateur de courant selon l'invention,
- la figure 2 représente le transformateur de courant 1 vu du côté d'une première face inférieure d'un premier circuit imprimé utilisé pour réaliser des bobines du transformateur de courant et pour maintenir avec précision des pièces magnétiques,
- la figure 3 est une vue en perspective d'une bobine composée de spires formées dans l'épaisseur du circuit imprimé,
- la figure 4 est une vue d'une face d'un circuit imprimé pour montrer l'agencement de tronçons de spires des bobines du transformateur de courant,
- la figure 5 est un schéma de câblage des bobines du transformateur de courant,
- la figure 6 est une vue éclatée d'un second mode de réalisation du transformateur de courant selon l'invention,
- la figure 7 illustre, sous forme d'un schéma bloc, différents modules fonctionnels d'un appareil de mesure du courant comportant un transformateur de courant selon l'invention, et
- la figure 8 est une vue éclatée de l'appareil de mesure du courant.

### DESCRIPTION DETAILLEE DE MODES DE REALISATION PREFERES

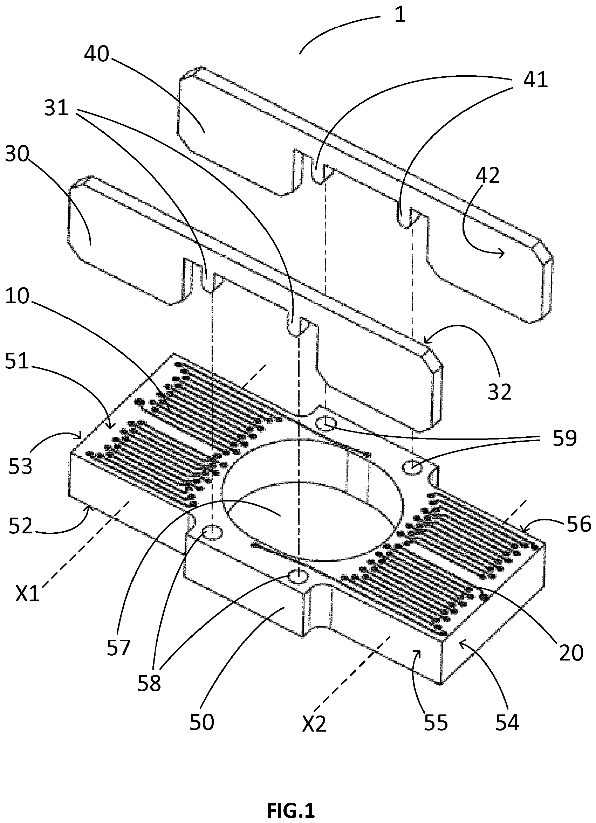

La figure 1 est une vue éclatée d'un premier mode de réalisation d'un transformateur de courant 1 selon l'invention. Ledit transformateur de courant 1 comporte une première bobine 10 et une deuxième bobine 20, réalisées au moyen d'un premier circuit imprimé 50 de forme sensiblement parallélépipédique. Ledit premier circuit imprimé 50 comporte une première face supérieure 51, une première face inférieure 52, un premier côté 53, un deuxième côté 54, le deuxième côté 54 étant opposé au premier côté 53 dans le parallélépipède formé par le circuit imprimé 50, un troisième côté 55, un quatrième côté 56, le quatrième côté 56 étant opposé au troisième côté 55. La première bobine 10 étant formée de premières spires, formées dans l'épaisseur du premier circuit imprimé 50, bobinées selon un premier axe de bobinage X1 sensiblement perpendiculaire au troisième et au quatrième côtés 55, 56. La deuxième bobine 20 est formée de secondes spires bobinées selon un second axe de bobinage X2 sensiblement perpendiculaire au troisième et au quatrième côtés 55, 56. Le premier circuit imprimé 50 comporte une première ouverture 57 dans les deux faces 51, 52 pour former un passage traversant à une ligne de courant 2, ladite ligne de courant formant un circuit primaire du transformateur de courant 1. La première bobine et la deuxième bobines 10, 20 sont disposées de part et d'autre de la première ouverture 57 et forment un circuit secondaire du transformateur de courant 1.

Le transformateur de courant 1 comporte également une première pièce magnétique 30 de forme allongée comportant une première face de référence 32 et au moins une seconde pièce magnétique 40 de forme allongée comportant une seconde face de référence 42. Pour rationaliser une production industrielle du transformateur de courant 1, la première et la second pièces magnétiques 30, 40 sont préférentiellement identiques. Le matériau des pièces magnétiques est préférentiellement composé de fer et de nickel.

Afin de mesurer les courants électriques avec une excellente précision, il faut limiter le plus possible la diaphonie c'est-à-dire l'influence des champs magnétiques externes non liés au courant à mesurer circulant dans la ligne de courant 2. Pour cela, il est nécessaire de maîtriser précisément le positionnement des pièces magnétiques 30, 40 par rapport aux spires des premières et deuxièmes bobines 10, 20. Le positionnement des spires sur le circuit imprimé est réalisable industriellement en grande série avec une précision de +/- 50 microns. De même, la très grande maîtrise industrielle de la planéité du circuit imprimé garantit une grande maîtrise de la surface de chaque spire. Un problème à résoudre est le positionnement avec précision et reproductibilité des première et seconde pièces magnétiques 30, 40 par rapport aux spires des premières et deuxièmes bobines 10, 20 et par conséquent, par rapport au premier circuit imprimé 50. Pour cela, le premier circuit imprimé 50 comporte un premier moyen de positionnement 58, disposé à proximité du troisième côté 55, et un second moyen de positionnement 59 disposé à proximité du quatrième côté 56. La première pièce magnétique 30 comporte un premier moyen de maintien 31, la seconde pièce magnétique 40 comporte un second moyen de maintien 41. Le premier moyen de positionnement 58 est agencé pour s'assembler avec le premier moyen de maintien 31 pour maintenir la première face de référence 32 à une distance prédéterminée et précise en vis-à-vis du troisième côté 55. Le second moyen de positionnement 59 est agencé pour s'assembler avec le second moyen de maintien 41 pour maintenir la seconde face de référence 42 à une distance prédéterminée et précise en vis-à-vis du cinquième côté 56. De cette façon, en maîtrisant d'une part le positionnement précis des pièces magnétiques par rapport aux troisième et quatrième côtés 55, 56, et d'autre part, en maîtrisant avec une grande précision le positionnement des spires des première et deuxième bobines sur le circuit imprimé et tout particulièrement par rapport aux troisième et quatrième côtés, alors le positionnement des spires des première et deuxième bobines vis-à-vis des pièces magnétiques est réalisé avec une grande précision et peut être reproduit industriellement, avec cette même précision, en grande série.

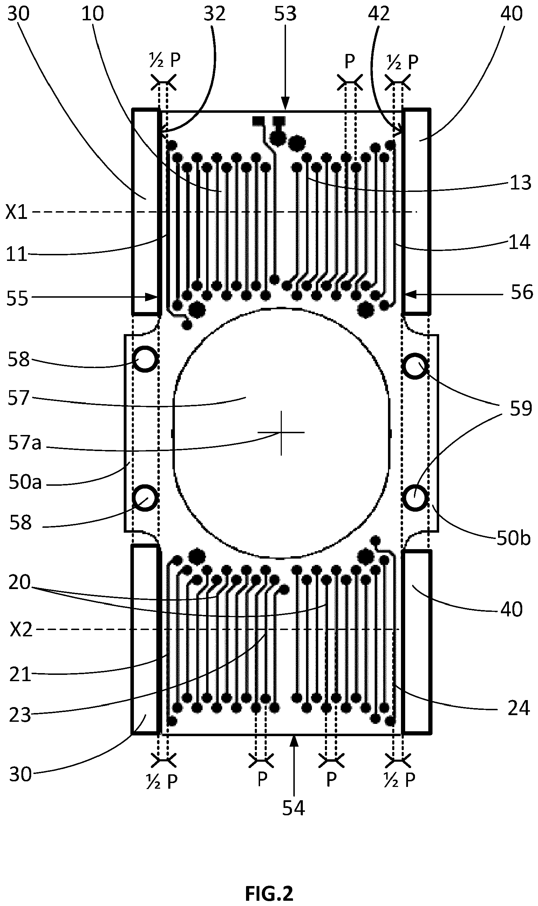

Préférentiellement, le premier moyen de positionnement 58 et le second moyen de positionnement 59 sont au moins un trou percé dans le premier circuit imprimé 50, le premier moyen de maintien 31 est au moins un ergot dimensionné et agencé pour être inséré dans le premier moyen de positionnement 58, et le second moyen de maintien 41 est au moins un ergot dimensionné et agencé pour être inséré dans le second moyen de positionnement 59. Préférentiellement, le premier moyen de maintien 31 est au moins un ergot de section carrée dont la dimension du côté est légèrement inférieure ou égale au diamètre du trou correspondant au premier moyen de positionnement 58. Ainsi, l'ergot rentre en force dans le trou de positionnement et se centre naturellement dans le trou de positionnement 58. L'extrémité de l'ergot est préférentiellement biseautée afin d'accentuer l'effet de centrage de l'ergot correspondant au premier moyen de maintien 31 dans le trou correspondant au premier moyen de positionnement 58. En variante, des harpons sont formés en surface des moyens de maintien 31, 41 pour fixer solidement les pièces magnétiques 30, 40 dans le premier circuit imprimé 50. Le second moyen de maintien 41 et le second moyen de positionnement 59 sont respectivement identiques au premier moyen de maintien 31 et au premier moyen de positionnement 58. Préférentiellement, plusieurs ergots constituent chaque premier moyen de positionnement 31 ou chaque second moyen de positionnement 41 et plusieurs trous de positionnement constituent chaque premier moyen de positionnement 58 et chaque second moyen de positionnement 59 ainsi que représenté sur la figure 1. D'autres solutions telles que des ergots coniques peuvent être employées dans la mesure où le moyen de maintien coopère sans jeu avec le moyen de positionnement. La figure 2 représente le transformateur de courant 1 vu du côté de la première face inférieure 52 du premier circuit imprimé 50. Préférentiellement, la première pièce magnétique 30 et la seconde pièce magnétique 40 sont réalisées au moyen de plaques parallélépipédiques en matériau métallique magnétique. Les premiers et seconds moyens de maintien 31, 41 sont préférentiellement découpés respectivement dans la première pièce magnétique 30 et dans la seconde pièce magnétique 40 par découpe à plat ou poinçonnage. Le premier circuit imprimé 50 comporte une première protubérance 50a formée sur le troisième côté 55 du premier circuit imprimé 50 et comporte une deuxième protubérance 50b formée sur le quatrième côté 56 dudit premier circuit imprimé 50. Préférentiellement, au moins un trou correspondant au premier moyen de positionnement 58 est formé dans la première protubérance 50a et au moins un trou correspondant au second moyen de positionnement 59 est formé dans la deuxième protubérance 50b. De cette façon, le premier moyen de positionnement 58 et le second moyen de positionnement 59 sont positionnés dans l'axe des première et secondes pièces magnétiques ce qui simplifie l'assemblage, réduit le nombre de pièces et favorise la compacité du transformateur de courant 1.

En variante non représentée, le premier circuit imprimé 50 peut être formé de deux demi-circuit imprimés indépendants, un premier demi-circuit imprimé pour former la première bobine 10, un second demi-circuit imprimé pour former la deuxième bobine 20, les deux demi-circuits imprimés étant maintenus et positionnés par les premier et second moyens de maintien des pièces magnétiques 31, 41.

La première bobine 10 et la deuxième bobine 20 sont formées de spires réalisées dans l'épaisseur du premier circuit imprimé 50, lesdites spires étant bobinées avec un pas de bobinage P constant, ainsi que le montre la figure 2. Préférentiellement, le pas de bobinage P est compris entre 50 et 700 microns. De plus, afin de réduire l'influence des perturbations apportées par des champs magnétiques externes, la première face de référence 32 et la seconde face de référence 42 dépassent la première face supérieure 51 et la première face inférieure 52 du premier circuit imprimé 50 d'une distance supérieure à un pas de bobinage P. Le premier circuit imprimé 50 est ainsi encadré par la première pièce magnétique 30 et la seconde pièce magnétique 40 sur les troisième et quatrième côtés 55, 56.

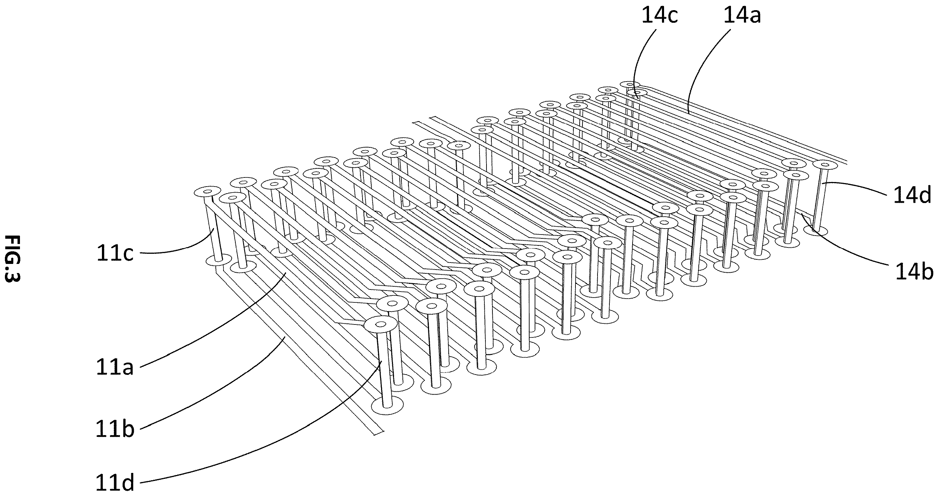

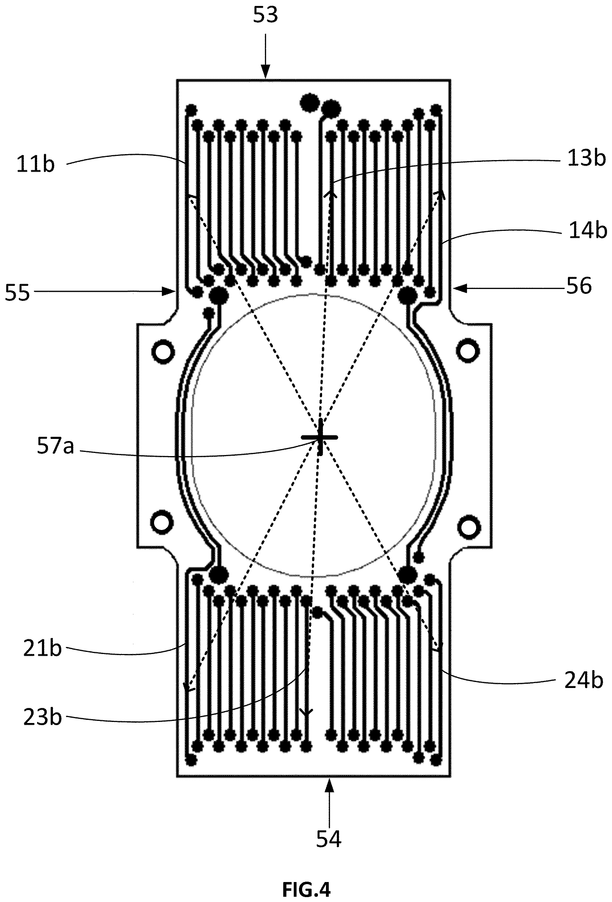

Chaque spire de chaque bobine est réalisée par un premier tronçon conducteur sur la première face supérieure 51 du premier circuit imprimé 50 et un second tronçon conducteur sur la première face inférieure 52 dudit premier circuit imprimé 50 ainsi que représenté sur la figure 3. Les extrémités des premiers tronçons sont reliées aux extrémités des seconds tronçons par des liaisons conductrices dénommées « vias » selon un mode de réalisation conventionnel. Par exemple, une première spire latérale 11 de la première bobine 10 est réalisée par un premier tronçon 11a sur la première face supérieure 51, ledit premier tronçon étant relié à un second tronçon 11b sur la première face inférieure 52 au moyen d'un premier « via » 11c. Un second « via » 11d relie la première spire 11 à une spire suivante. La première bobine 10 comporte également une seconde spire latérale 14 composée de premier et second tronçons 14a, 14b et de premier et seconds « vias » 14c, 14d. Afin de réduire l'influence des champs magnétiques perturbateurs externes, les premiers tronçons conducteurs des spires de la première bobine 10 sont symétriques, par rapport au centre 57a de la première ouverture 57, des premiers tronçons conducteurs des spires de la deuxième bobine 20 et les seconds tronçons conducteurs des spires de la première bobine 10 sont symétriques, par rapport au centre 57a de la première ouverture 57, des seconds tronçons conducteurs des spires de la deuxième bobine 20, ainsi que représenté sur la figure 4. Un premier tronçon 13b d'une spire quelconque 13 de la première bobine 10 possède un symétrique 23b par rapport au centre 57a.

Ainsi que représenté en figure 2, la première spire latérale 11 de la première bobine 10 est disposée à une première extrémité de la première bobine 10 en regard de la première face de référence 32 de la première pièce magnétique 30, et la deuxième spire latérale 14 est disposée à une deuxième extrémité de la première bobine 10 en regard de la seconde face de référence 42 de la seconde pièce magnétique 40. De la même façon, la deuxième bobine 20 comporte une troisième spire latérale 21 à une troisième extrémité en regard de la première face de référence 32, et une quatrième spire latérale 24 à une quatrième extrémité en regard de la seconde face de référence 42. Avantageusement, la première bobine 10 et la deuxième bobine 20 sont disposées sur le premier circuit imprimé 50 de telle manière que :
- la distance entre la première spire latérale 11 de la première bobine 10 et la première face de référence 32 est sensiblement égale à la moitié du pas de bobinage P soit P/2,
- la distance entre la première spire latérale 21 de la deuxième bobine 20 et la première face de référence 32 est sensiblement égale à la moitié du pas de bobinage P,
- la distance entre la seconde spire latérale 14 de la première bobine 10 et la seconde face de référence 42 est sensiblement égale à la moitié du pas de bobinage P, et
- la distance entre la seconde spire latérale 24 de la deuxième bobine 20 et la seconde face de référence 42 est sensiblement égale à la moitié du pas de bobinage P.
De cette façon, les pièces magnétiques ayant une excellente perméabilité magnétique et se comportant comme des shunts magnétiques vis-à-vis de la première bobine 10 et de la seconde bobine 20, la distance entre la première spire latérale 11 de la première bobine 10 et la première spire latérale 21 de la deuxième bobine 20 est égale à deux fois la moitié du pas de bobinage P soit un pas de bobinage P. Il en est de même pour la distance entre la seconde spire latérale 14 de la première bobine 10 et la seconde spire latérale 24 de la deuxième bobine 20. Ainsi, la première bobine 10 et la seconde bobine 20 forment virtuellement un ensemble de spires ininterrompu, équivalent à une bobine unique, bobinée avec un pas de bobinage constant égal à P. Le positionnement avec précision de la première face de référence 32 à une distance prédéterminée du troisième côté 55 et par conséquent à une distance précise de la première spire latérale 11 est très important pour garantir le pas de bobinage rigoureusement constant de l'ensemble de spires formé par la première bobine 10 et la seconde bobine 20. La même contrainte de positionnement s'applique à toutes les spires latérales des bobines du transformateur de courant 1. Afin de mettre en œuvre scrupuleusement ladite contrainte de positionnement et compte tenu de la nécessité de former une pastille de connexion entre chaque extrémité de tronçon et le « via » auquel l'extrémité est connectée, au moins un des premiers tronçons 11a ou 14a ou au moins un des seconds tronçons 11b ou 14b de la première spire latérale 11 de la première bobine 10 est recourbé en forme de « C » dont les extrémités s'éloignent respectivement de la première face de référence 32 et de la seconde face de référence 42. Lesdits « vias » sont donc disposés à une distance supérieure à un demi pas de bobinage P des faces de référence 32, 42. Le premier tronçon 11a représenté sur la figure 3 illustre cette disposition particulière. Cette disposition est reproduite sur au moins un des premiers ou seconds tronçons 21a, 21b de la première spire latérale 21 de la deuxième bobine 20 ou un des premiers ou seconds tronçons 24a, 24b de la seconde spire latérale 24 de la deuxième bobine 20.

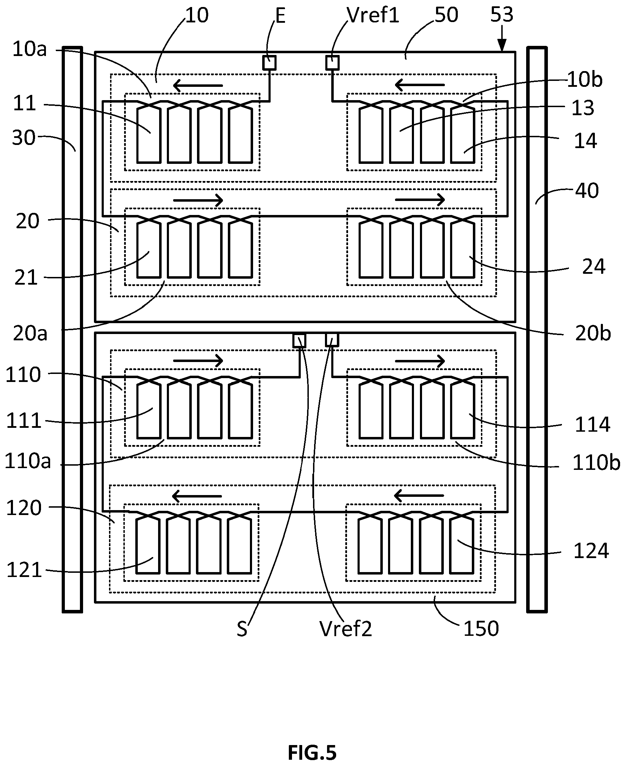

La première et la deuxième bobine 10, 20 sont destinées à délivrer un signal représentatif d'un courant électrique à mesurer dans la ligne de courant 2. Pour cela, ainsi que représenté en figure 5, la première bobine 10 et la deuxième bobine 20 sont connectées électriquement en série de la façon suivante :
- la première spire latérale 11 de la première bobine 10 est reliée à la première spire latérale 21 de la deuxième bobine 20, et
- la seconde spire latérale 14 de la première bobine est reliée à la seconde spire latérale 24 de la deuxième bobine.
De plus, la première bobine 10 est composée de :
- une première demi-bobine 10a comprenant un premier point de connexion électrique E, et
- une deuxième demi-bobine 10b comprenant un second point de connexion électrique Vref1,
le premier et le second points de connexion étant localisés sensiblement au milieu du premier côté 53. Une mesure du signal électrique entre le premier point de connexion E et le second point de connexion Vref1 fournit une mesure du courant électrique circulant dans la ligne de courant 2. Pour respecter une symétrie parfaite de la première bobine 10 et de la seconde bobine 20 par rapport au centre 57a de la première ouverture 57, la seconde bobine est également composée de deux demi-bobines 20a, 20b connectées en série.

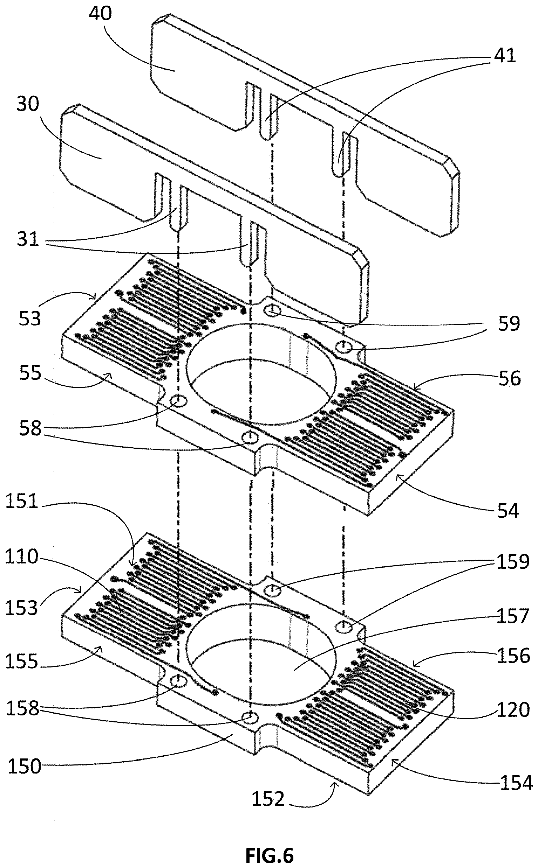

Le transformateur de courant 1, ainsi décrit, possède permet une mesure de courant avec une grande précision. Afin d'augmenter le niveau de signal électrique et encore améliorer l'immunité aux champs magnétiques externes, un second mode de réalisation est représenté en figure 6. Le transformateur de courant 1 comporte une troisième bobine 110 et une quatrième bobine 120 réalisées au moyen d'un second circuit imprimé 150 de forme sensiblement parallélépipédique, comportant une seconde face supérieure 151, une seconde face inférieure 152, un cinquième côté 153, un sixième côtés 154, le sixième côté 154 étant opposé au cinquième côté 153, un septième côté 155, un huitième côté 156, le huitième côté 156 étant opposé au septième côté 155. La troisième bobine 110 et la quatrième bobines 120 sont bobinées respectivement selon des axes parallèles au premier et au second axe de bobinage X1, X2. Le second circuit imprimé 150 comporte une seconde ouverture 157 dans les deux secondes faces 151, 152 pour former un passage traversant à la ligne de courant 2, la troisième bobine 110 et la quatrième bobine 120 étant disposées de part et d'autre de la seconde ouverture 157. Pour maîtriser précisément le positionnement des pièces magnétiques 30, 40 par rapport aux spires des troisième et quatrième bobines 110, 120, le second circuit imprimé 150 comporte, au moins :
- un troisième moyen de positionnement 158 agencé pour s'assembler avec le premier moyen de maintien 31 pour maintenir avec précision la première face de référence 32 à une distance prédéterminée du septième côté 155, et
- un quatrième moyen de positionnement 159 agencé pour s'assembler avec le second moyen de maintien 41 pour maintenir avec précision la seconde face de référence 42 à une distance prédéterminée du huitième côté 156.
Ainsi, de façon analogue au positionnement des première et deuxième bobines 10, 20, en maîtrisant le positionnement des pièces magnétiques 30 et 40 par rapport aux septième et huitième côtés, 155, 156, et les spires des troisième et quatrième bobines étant positionnées avec grande précision sur le circuit imprimé, tout particulièrement par rapport aux septième et huitième côtés 155, 156, le positionnement des spires des troisième et quatrième bobines vis-à-vis des pièces magnétiques 30, 40 est réalisé avec une grande précision. Le premier circuit imprimé 50 et le second circuit imprimé 150 sont préférentiellement accolés l'un à l'autre.

La troisième bobine 110 et la quatrième bobine 120 sont formées de spires réalisées dans l'épaisseur du second circuit imprimé 150, de manière similaire à la première bobine 10 et à la deuxième bobine 20 formées de spires réalisées dans l'épaisseur du premier circuit imprimé 50. Pour accroître l'immunité aux champs magnétiques externes, la troisième bobine 110 est bobinée selon un sens inverse par rapport au sens de bobinage de la première bobine 10, et la quatrième bobine 120 est bobinée selon un sens inverse par rapport au sens de bobinage de la deuxième bobine 20. Le sens de bobinage est représenté par une flèche située au-dessus de chacune des différentes bobines sur la figure 5. De manière équivalente au premier mode de réalisation, la première face de référence 32 et la seconde face de référence 42 dépassent la première face supérieure 51 du premier circuit imprimé 50 et la seconde face inférieure 152 du second circuit imprimé 150 d'une distance supérieure à un pas de bobinage P. Le premier circuit imprimé 50 et le second circuit imprimé 150 sont ainsi encadré par la première pièce magnétique 30 et la seconde pièce magnétique 40.

De manière similaire à la première bobine 10 et à la deuxième bobine 20, la troisième bobine 110 comporte :
- une troisième demi-bobine 110a comprenant un troisième point de connexion électrique S, et
- une quatrième demi-bobine 110b comprenant un quatrième point de connexion électrique Vref2,
le troisième point de connexion électrique S et le quatrième point de connexion électrique Vref2 étant localisés sensiblement au milieu du cinquième côté 153.
Pour respecter une symétrie parfaite de la troisième bobine 110 et de la quatrième bobine 120 par rapport au centre de la seconde ouverture 157, ladite quatrième bobine 120 est également composée de deux demi-bobines 120a, 120b connectées en série. Le transformateur de courant 1 ainsi formé peut fournir :
- un premier signal de mesure M1 représentatif du courant circulant dans la ligne de courant 2 passant dans la première ouverture 57, et
- un second signal de mesure M2 représentatif du courant circulant dans la ligne de courant 2 passant dans la seconde ouverture 157 du dispositif de mesure du courant 1.
Le premier signal de mesure M1 est le signal présent entre le premier point de connexion électrique E et le second point de connexion électrique Vref1. Le second signal de mesure M2 est le signal présent entre le troisième point de connexion électrique S, et le quatrième point de connexion électrique Vref2. La mesure M est issue d'une mesure du premier signal de mesure M1 et du second signal de mesure M2. Préférentiellement, les points de connexion Vref1 et Vref2 sont reliés à un même potentiel de référence et la mesure M est le résultat d'une mesure de la tension différentielle, par rapport audit potentiel de référence, entre le premier point de connexion électrique E et le troisième point de connexion électrique S. La mesure M correspond ainsi à la mesure du premier signal M1 additionnée à la mesure du second signal M2.

Plus généralement, afin d'augmenter le niveau de signal électrique, le transformateur de courant 1 peut comporter autant de bobines 10, 20, 110, 120 que nécessaires, formées dans autant de circuits imprimés 50, 150 que nécessaire dans la mesure où les circuits imprimés comportent des moyens de positionnement agencés pour s'assembler avec les moyens de maintien pour maintenir avec précision les faces de référence des pièces magnétiques à distance prédéterminée des côtés des circuits imprimés.

Dans l'objectif de réduire l'influence des perturbations apportées par des champs électro-magnétiques externes sur les connexions entre le transformateur de courant 1 et des circuits de mesure des signaux délivrés au niveau des points de connexion E, S, Vref1 et Vref2, le premier circuit imprimé 50 ou le second circuit imprimé 150 comportent une troisième protubérance 50c formée sur préférentiellement sur le premier ou le deuxième côté 53, 54 pour implanter :
- des circuits de mesure pour traiter des signaux délivrés par les première, deuxième, troisième et quatrième bobines 10, 20, 110, 120 et fournir un signal de mesure M représentatif du courant circulant dans la ligne de courant 2,
- des connexions électriques pour transmettre le signal de mesure à un appareil de mesure 5.
De cette façon, la longueur des connexions entre le transformateur de courant 1 et les circuits de mesure est minimisée, minimisant en conséquence l'influence des perturbations externes.

Les caractéristiques techniques décrites précédemment permettent de réaliser un transformateur de courant 1 délivrant un signal de mesure M extrêmement précis sans nécessiter de réglage ou calibrage, tout en bénéficiant d'une grande immunité aux perturbations électro-magnétiques externes : un taux de diaphonie meilleur que 0,2 % est atteignable. L'utilisation de la technologie de circuit imprimé permettant une précision de réalisation élevée et une production en grande série industrielle associée à une conception simple et astucieuse d'assemblage des pièces magnétiques avec les circuits imprimés permet d'obtenir un produit de haute performance à un prix de revient réduit. De plus, la réalisation du transformateur de courant 1 étant extrêmement compacte, ledit transformateur peut être implanté dans une installation électrique où les lignes de courant 2 sont très rapprochées. Le transformateur de courant selon l'invention peut également être utilisé dans un appareil de protection ou de commande des circuits de distribution électrique tel qu'un disjoncteur ou un contacteur.

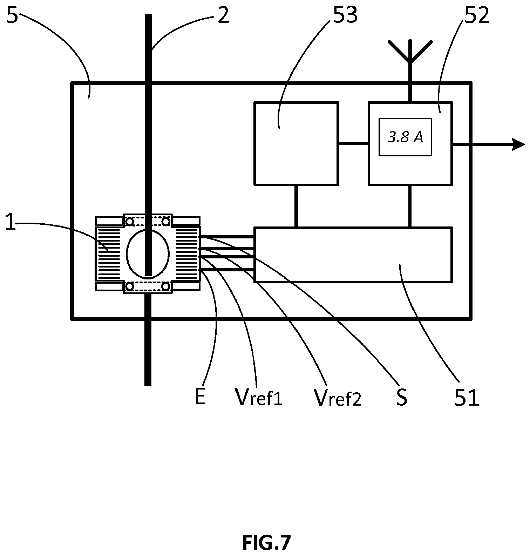

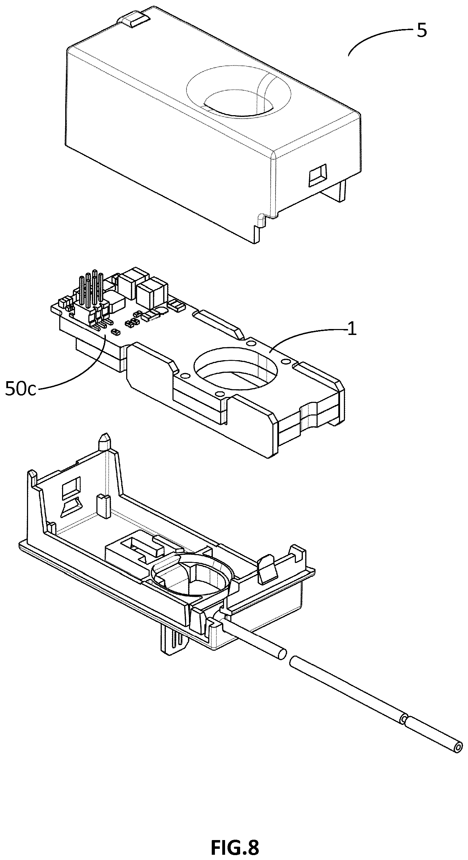

L'invention porte également sur un appareil de mesure 5 du courant circulant dans une ligne de courant 2 d'une installation électrique et comportant un transformateur de courant selon l'invention. Un tel appareil de mesure est représenté, en figure 7, sous forme d'un schéma bloc et en figure 8 sous forme d'une vue éclatée. Ledit appareil de mesure 5 comporte :
- un circuit de mesure 51 pour fournir une mesure M de l'amplitude du courant circulant dans la ligne de courant 2,
- un circuit d'interface 52 relié au circuit de mesure 51 pour afficher localement la mesure M du signal de mesure ou transmettre la valeur de ladite mesure M par un moyen radio, par exemple de type NFC, Bluetooth, ZigBee ou RFID, ou par une communication filaire,
- un circuit d'alimentation 53 pour alimenter le circuit de mesure 51 et le circuit d'interface 52, et
- un transformateur de courant 1 tel que décrit précédemment, comportant une première ouverture 57 et une seconde ouverture 157 dans lesquelles passe la ligne de courant 2, ledit transformateur de courant 1 étant connecté au circuit de mesure 51 pour fournir audit circuit de mesure 51 :
- un premier signal de mesure M1 représentatif du courant circulant dans la ligne de courant 2 passant dans la première ouverture 57, et
- un second signal de mesure M2 représentatif du courant circulant dans la ligne de courant 2 passant dans la seconde ouverture 157 du dispositif de mesure du courant 1.

Un tel appareil de mesure 5 est très précis, très peu sensible aux perturbations externes et peu volumineux. Il est particulièrement destiné à la mesure de courant, de la puissance ou de l'énergie dans une installation électrique.

## Revendications

1. Transformateur de courant (1) comportant :
- une première bobine (10) et une deuxième bobine (20), réalisées au moyen d'un premier circuit imprimé (50) de forme sensiblement parallélépipédique, comportant une première face supérieure (51), une première face inférieure (52), un premier côté (53), un deuxième côté (54), le deuxième côté (54) étant opposé au premier côté (53), un troisième côté (55), un quatrième côté (56), le quatrième côté (56) étant opposé au troisième côté (55), la première bobine (10) étant formée de premières spires (11, 13, 14) bobinées selon un premier axe de bobinage (X1) sensiblement perpendiculaire au troisième et au quatrième côtés (55, 56), la deuxième bobine (20) étant formée de secondes spires (21, 23, 24) bobinées selon un second axe de bobinage (X2) sensiblement perpendiculaire au troisième et au quatrième côtés (55, 56), le premier circuit imprimé (50) comportant une première ouverture (57) dans les premières faces supérieure et inférieure (51, 52) pour former un passage traversant à une ligne de courant (2), ladite ligne de courant formant un circuit primaire du transformateur de courant, la première bobine et la deuxième bobines (10, 20) étant disposées de part et d'autre de la première ouverture (57) et formant un circuit secondaire, et
- une première pièce magnétique (30) de forme allongée comportant une première face de référence (32) et au moins une seconde pièce magnétique (40) de forme allongée comportant une seconde face de référence (42),
transformateur de courant (1) **caractérisé en ce que** :
- le premier circuit imprimé (50) comportant un premier moyen de positionnement (58), disposé à proximité du troisième côté (55), et un second moyen de positionnement (59) disposé à proximité du quatrième côté (56),
- la première pièce magnétique (30) comportant un premier moyen de maintien (31),
- la seconde pièce magnétique (40) comportant un second moyen de maintien (41), le premier moyen de positionnement (58) est agencé pour s'assembler avec le premier moyen de maintien (31) pour maintenir la première face de référence (32) à une distance prédéterminée en vis-à-vis du troisième côté (55), et le second moyen de positionnement (59) est agencé pour s'assembler avec le second moyen de maintien (41) pour maintenir la seconde face de référence (42) à une distance prédéterminée en vis-à-vis du cinquième côté (56).

2. Transformateur de courant selon la revendication 1 **caractérisé en ce que** :
- le premier moyen de positionnement (58) et le second moyen de positionnement (59) sont des trous percés dans le premier circuit imprimé (50),
- le premier moyen de maintien (31) est un ergot agencé pour être inséré dans le premier moyen de positionnement (58), et
- le second moyen de maintien (41) est un ergot agencé pour être inséré dans le second moyen de positionnement (59).

3. Transformateur de courant selon la revendication précédente **caractérisé en ce que** :
- le premier moyen de positionnement (58) est disposé dans une première protubérance (50a) formée sur le troisième côté (55) du premier circuit imprimé (50),
- le second moyen de positionnement (59) est disposé dans une deuxième protubérance (50b) formée sur le quatrième côté (56) dudit premier circuit imprimé (50),
- le premier moyen de maintien (31) est formé par une découpe de la première pièce magnétique (30), et
- le second moyen de maintien (41) est formé par une découpe de la seconde pièce magnétique (40).

4. Transformateur de courant selon l'une quelconque des revendications précédentes **caractérisé en ce que** la première bobine (10) et la deuxième bobine (20) sont formées de spires bobinées avec un pas de bobinage (P) constant.

5. Transformateur de courant selon la revendication précédente **caractérisé en ce que** le pas de bobinage (P) est compris entre 50 et 700 microns.

6. Transformateur de courant selon l'une des revendications 4 ou 5 **caractérisé en ce que** la première face de référence (32) et la seconde face de référence (42) dépassent la première face supérieure (51) et la première face inférieure (52) d'une distance supérieure à un pas de bobinage (P).

7. Transformateur de courant selon l'une quelconque des revendications 4 à 6 **caractérisé en ce que** chaque spire étant réalisée dans l'épaisseur du premier circuit imprimé (50) et comportant un premier tronçon conducteur sur la première face supérieure (51) du premier circuit imprimé (50) et un second tronçon conducteur sur la première face inférieure (52) dudit premier circuit imprimé (50), les premiers tronçons conducteurs des spires de la première bobine (10) sont symétriques, par rapport au centre (57a) de la première ouverture (57), des premiers tronçons conducteurs des spires de la deuxième bobine (20) et les seconds tronçons conducteurs des spires de la première bobine (10) sont symétriques, par rapport au centre (57a) de la première ouverture (57), des seconds tronçons conducteurs des spires de la deuxième bobine (20).

8. Transformateur de courant selon l'une quelconque des revendications 4 à 7 **caractérisé en ce que**, la première bobine (10) comportant une première spire latérale (11) à une première extrémité en regard de la première face de référence (32), et une deuxième spire latérale (14) à une deuxième extrémité en regard de la seconde face de référence (42), et la deuxième bobine (20) comportant une troisième spire latérale (21) à une troisième extrémité en regard de la première face de référence (32), et une quatrième spire latérale (24) à une quatrième extrémité en regard de la seconde face de référence (42), la première bobine (10) et la deuxième bobine (20) sont disposées sur le premier circuit imprimé (50) de telle manière que :
- la distance entre la première spire latérale (11) de la première bobine (10) et la première face de référence (32) est sensiblement égale à la moitié du pas de bobinage (P),
- la distance entre la première spire latérale (21) de la deuxième bobine (20) et la première face de référence (32) est sensiblement égale à la moitié du pas de bobinage (P),
- la distance entre la seconde spire latérale (14) de la première bobine (10) et la seconde face de référence (42) est sensiblement égale à la moitié du pas de bobinage (P), et
- la distance entre la seconde spire latérale (24) de la deuxième bobine (20) et la seconde face de référence (42) est sensiblement égale à la moitié du pas de bobinage (P).

9. Transformateur de courant selon la revendication précédente **caractérisé en ce que** les extrémités d'au moins un des premiers ou seconds tronçons (11a, 11b, 14a, 14b, 21a, 21b, 24a, 24b) respectivement de la première spire latérale (11, 21) et de la seconde spire latérale (14, 24) de la première bobine (10) et de la deuxième bobine (20) sont recourbées pour former un C dont les extrémités s'éloignent respectivement de la première face de référence (32) et de la seconde face de référence (42).

10. Transformateur de courant selon l'une des revendications 8 ou 9 **caractérisé en ce que** la première et la deuxième bobine (10, 20) sont connectées électriquement en série, la première spire latérale (11) de la première bobine (10) étant reliée à la première spire latérale (21) de la deuxième bobine (20) et la seconde spire latérale (14) de la première bobine étant reliée à la seconde spire latérale (24) de la deuxième bobine.

11. Transformateur de courant selon la revendication précédente **caractérisé en ce que** la première bobine (10) est composée de :
- une première demi-bobine (10a) comprenant un premier point de connexion électrique (E), et
- une deuxième demi-bobine (10b) comprenant un second point de connexion électrique (Vref1),
le premier et le second point de connexion étant localisés sensiblement au milieu du premier côté (53).

12. Transformateur de courant selon l'une quelconque des revendications précédentes **caractérisé en ce qu'**il comporte une troisième bobine (110) et une quatrième bobine (120) réalisées au moyen d'un second circuit imprimé (150) de forme sensiblement parallélépipédique, comportant une seconde face supérieure (151), une seconde face inférieure (152), un cinquième côté (153), un sixième côté (154), le sixième côtés (154) étant opposé au cinquième côté (153), un septième côté (155), un huitième côté (156), le huitième côté (156) étant opposé au septième côté (155), la troisième et la quatrième bobines (110, 120) étant bobinées respectivement selon des axes parallèles au premier et au second axe de bobinage (X1, X2), le second circuit imprimé (150) comportant une seconde ouverture (157) dans les deux secondes faces (151, 152) pour former un passage traversant au conducteur électrique, la troisième bobine (110) et la quatrième bobine (120) étant disposées de part et d'autre de la seconde ouverture (157).

13. Transformateur de courant selon la revendication précédente **caractérisé en ce que** le second circuit imprimé (150) comporte :
- un troisième moyen de positionnement (158) agencé pour s'assembler avec le premier moyen de maintien (31) pour maintenir la première face de référence (32) à une distance prédéterminée du septième côté (155), et
- un quatrième moyen de positionnement (159) agencé pour s'assembler avec le second moyen de maintien (41) pour maintenir la seconde face de référence (42) à une distance prédéterminée du huitième côté (156).

14. Transformateur de courant selon l'une des revendications 12 ou 13 **caractérisé en ce que**, la troisième bobine (110) et la quatrième bobine (120) étant formées de spires réalisées dans l'épaisseur du second circuit imprimé (150) :
- la troisième bobine (110) est bobinée selon un sens inverse par rapport au sens de bobinage de la première bobine (10), et
- la quatrième bobine (120) est bobinée selon un sens inverse par rapport au sens de bobinage de la deuxième bobine (20).

15. Transformateur de courant selon l'une quelconque des revendications 12 à 14 **caractérisé en ce que** la troisième bobine (110) comporte :
- une troisième demi-bobine (110a) comprenant un troisième point de connexion électrique (S), et
- une quatrième demi-bobine (110b) comprenant un quatrième point de connexion électrique (Vref2),
le troisième point de connexion électrique (S) et le quatrième point de connexion électrique (Vref2) étant localisés sensiblement au milieu du cinquième côté (153).

16. Transformateur de courant selon l'une quelconque des revendications 12 à 15 **caractérisé en ce que** le premier circuit imprimé (50) ou le second circuit imprimé (150) comporte une troisième protubérance (50c) pour implanter :
- des circuits de mesure pour traiter des signaux délivrés par les première, deuxième, troisième et quatrième bobines (10, 20, 110, 120) et fournir un signal de mesure (M) représentatif du courant circulant dans la ligne de courant (2),
- des connexions électriques pour transmettre le signal de mesure (M) à un appareil de mesure (5).

17. Appareil de mesure (5) du courant circulant dans une ligne de courant (2) d'une installation électrique **caractérisé en ce qu'**il comporte :
- un transformateur de courant (1) selon l'une des revendications 1 à 16, comportant une première ouverture (57) et une seconde ouverture (157) dans lesquelles passe une ligne de courant (2), ledit transformateur de courant (1) fournissant :
- un premier signal de mesure (M1) représentatif du courant circulant dans la ligne de courant (2) passant dans la première ouverture (57), et
- un second signal de mesure (M2) représentatif du courant circulant dans la ligne de courant (2) passant dans la seconde ouverture (157) du dispositif de mesure du courant (1), et
- un circuit de mesure (51), connecté au transformateur de courant (1) pour recevoir le premier signal de mesure (M1) et le second signal de mesure (M2), ledit circuit de mesure (51) fournissant une mesure (M) de l'amplitude du courant circulant dans la ligne de courant (2), ladite mesure (M) étant issue d'une mesure du premier signal de mesure (M1) et du second signal de mesure (M2),
- un circuit d'interface (52) relié au circuit de mesure (51) pour afficher la mesure (M) du signal de mesure ou transmettre ladite mesure, et
- un circuit d'alimentation (53) pour alimenter le circuit de mesure (51) et le circuit d'interface (52).

## Patentansprüche

1. Stromtransformator (1), welcher aufweist:
- eine erste Wicklung (10) und eine zweite Wicklung (20), die mittels einer ersten Leiterplatte (50) von im Wesentlichen quaderförmiger Gestalt ausgebildet sind, die eine erste obere Fläche (51), eine erste untere Fläche (52), eine erste Seite (53), eine zweite Seite (54), wobei die zweite Seite (54) der ersten Seite (53) gegenüberliegt, eine dritte Seite (55), eine vierte Seite (56), wobei die vierte Seite (56) der dritten Seite (55) gegenüberliegt, aufweist, wobei die erste Wicklung (10) von ersten Windungen (11, 13, 14) gebildet wird, die gemäß einer ersten Wickelachse (X1) gewickelt sind, die im Wesentlichen senkrecht zur dritten und zur vierten Seite (55, 56) ist, wobei die zweite Wicklung (20) von zweiten Windungen (21, 23, 24) gebildet wird, die gemäß einer zweiten Wickelachse (X2) gewickelt sind, die im Wesentlichen senkrecht zur dritten und zur vierten Seite (55, 56) ist, wobei die erste Leiterplatte (50) eine erste Öffnung (57) in der ersten oberen und der ersten unteren Fläche (51, 52) aufweist, um einen Durchgang für eine Stromleitung (2) zu bilden, wobei die Stromleitung einen Primärkreis des Stromtransformators bildet, wobei die erste Wicklung und die zweite Wicklung (10, 20) beiderseits der ersten Öffnung (57) angeordnet sind und einen Sekundärkreis bilden, und
- ein erstes Magnetteil (30) von lang gestreckter Form, das eine erste Referenzfläche (32) aufweist, und wenigstens ein zweites Magnetteil (40) von lang gestreckter Form, das eine zweite Referenzfläche (42) aufweist,
wobei der Stromtransformator (1) **dadurch gekennzeichnet ist, dass**:
- die erste Leiterplatte (50) ein erstes Positionierungsmittel (58), das in der Nähe der dritten Seite (55) angeordnet ist, und ein zweites Positionierungsmittel (59), das in der Nähe der vierten Seite (56) angeordnet ist, aufweist,
- das erste Magnetteil (30) ein erstes Haltemittel (31) aufweist,
- das zweite Magnetteil (40) ein zweites Haltemittel (41) aufweist,
wobei das erste Positionierungsmittel (58) dafür ausgelegt ist, mit dem ersten Haltemittel (31) zusammengebaut zu werden, um die erste Referenzfläche (32) in einem vorbestimmten Abstand gegenüber der dritten Seite (55) zu halten, und das zweite Positionierungsmittel (59) dafür ausgelegt ist, mit dem zweiten Haltemittel (41) zusammengebaut zu werden, um die zweite Referenzfläche (42) in einem vorbestimmten Abstand gegenüber der fünften Seite (56) zu halten.

2. Stromtransformator nach Anspruch 1, **dadurch gekennzeichnet, dass**:
- das erste Positionierungsmittel (58) und das zweite Positionierungsmittel (59) Löcher sind, die in die erste Leiterplatte (50) gebohrt sind,
- das erste Haltemittel (31) ein Ansatz ist, der dafür ausgelegt ist, in das erste Positionierungsmittel (58) eingesteckt zu werden, und
- das zweite Haltemittel (41) ein Ansatz ist, der dafür ausgelegt ist, in das zweite Positionierungsmittel (59) eingesteckt zu werden.

3. Stromtransformator nach dem vorhergehenden Anspruch, **dadurch gekennzeichnet, dass**:
- das erste Positionierungsmittel (58) in einem ersten Vorsprung (50a) angeordnet ist, der auf der dritten Seite (55) der ersten Leiterplatte (50) ausgebildet ist,
- das zweite Positionierungsmittel (59) in einem zweiten Vorsprung (50b) angeordnet ist, der auf der vierten Seite (56) der ersten Leiterplatte (50) ausgebildet ist,
- das erste Haltemittel (31) von einem Ausschnitt des ersten Magnetteils (30) gebildet wird, und
- das zweite Haltemittel (41) von einem Ausschnitt des zweiten Magnetteils (40) gebildet wird.

4. Stromtransformator nach einem der vorhergehenden Ansprüche, **dadurch gekennzeichnet, dass** die erste Wicklung (10) und die zweite Wicklung (20) von Windungen gebildet werden, die mit einem konstanten Windungsabstand (P) gewickelt sind.

5. Stromtransformator nach dem vorhergehenden Anspruch, **dadurch gekennzeichnet, dass** der Windungsabstand (P) zwischen 50 und 700 Mikrometern liegt.

6. Stromtransformator nach einem der Ansprüche 4 oder 5, **dadurch gekennzeichnet, dass** die erste Referenzfläche (32) und die zweite Referenzfläche (42) über die erste obere Fläche (51) und die erste untere Fläche (52) um einen Abstand hinausragen, der größer als ein Windungsabstand (P) ist.

7. Stromtransformator nach einem der Ansprüche 4 bis 6, **dadurch gekennzeichnet, dass** jede Windung in der Dicke der ersten Leiterplatte (50) ausgebildet ist und einen ersten leitenden Abschnitt auf der ersten oberen Fläche (51) der ersten Leiterplatte (50) und einen zweiten leitenden Abschnitt auf der ersten unteren Fläche (52) der ersten Leiterplatte (50) aufweist, wobei die ersten leitenden Abschnitte der Windungen der ersten Wicklung (10) in Bezug auf den Mittelpunkt (57a) der ersten Öffnung (57) symmetrisch zu den ersten leitenden Abschnitten der Windungen der zweiten Wicklung (20) sind und die zweiten leitenden Abschnitte der Windungen der ersten Wicklung (10) in Bezug auf den Mittelpunkt (57a) der ersten Öffnung (57) symmetrisch zu den zweiten leitenden Abschnitten der Windungen der zweiten Wicklung (20) sind.

8. Stromtransformator nach einem der Ansprüche 4 bis 7, **dadurch gekennzeichnet, dass** die erste Wicklung (10) eine erste seitliche Windung (11) an einem ersten Ende gegenüber der ersten Referenzfläche (32) und eine zweite seitliche Windung (14) an einem zweiten Ende gegenüber der zweiten Referenzfläche (42) aufweist und die zweite Wicklung (20) eine dritte seitliche Windung (21) an einem dritten Ende gegenüber der ersten Referenzfläche (32) und eine vierte seitliche Windung (24) an einem vierten Ende gegenüber der zweiten Referenzfläche (42) aufweist, wobei die erste Wicklung (10) und die zweite Wicklung (20) auf der ersten Leiterplatte (50) derart angeordnet sind, dass:
- der Abstand zwischen der ersten seitlichen Windung (11) der ersten Wicklung (10) und der ersten Referenzfläche (32) im Wesentlichen gleich der Hälfte des Windungsabstands (P) ist,
- der Abstand zwischen der ersten seitlichen Windung (21) der zweiten Wicklung (20) und der ersten Referenzfläche (32) im Wesentlichen gleich der Hälfte des Windungsabstands (P) ist,
- der Abstand zwischen der zweiten seitlichen Windung (14) der ersten Wicklung (10) und der zweiten Referenzfläche (42) im Wesentlichen gleich der Hälfte des Windungsabstands (P) ist, und
- der Abstand zwischen der zweiten seitlichen Windung (24) der zweiten Wicklung (20) und der zweiten Referenzfläche (42) im Wesentlichen gleich der Hälfte des Windungsabstands (P) ist.

9. Stromtransformator nach dem vorhergehenden Anspruch, **dadurch gekennzeichnet, dass** die Enden wenigstens eines der ersten oder zweiten Abschnitte (11a, 11b, 14a, 14b, 21a, 21b, 24a, 24b) der ersten seitlichen Windung (11, 21) bzw. der zweiten seitlichen Windung (14, 24) der ersten Wicklung (10) bzw. der zweiten Wicklung (20) so gekrümmt sind, dass sie ein "C" bilden, dessen Enden sich von der ersten Referenzfläche (32) bzw. von der zweiten Referenzfläche (42) entfernen.

10. Stromtransformator nach einem der Ansprüche 8 oder 9, **dadurch gekennzeichnet, dass** die erste und die zweite Wicklung (10, 20) elektrisch in Reihe geschaltet sind, wobei die erste seitliche Windung (11) der ersten Wicklung (10) mit der ersten seitlichen Windung (21) der zweiten Wicklung (20) verbunden ist und die zweite seitliche Windung (14) der ersten Wicklung mit der zweiten seitlichen Windung (24) der zweiten Wicklung verbunden ist.

11. Stromtransformator nach dem vorhergehenden Anspruch, **dadurch gekennzeichnet, dass** die erste Wicklung (10) besteht:
- aus einer ersten Wicklungshälfte (10a), die einen ersten elektrischen Anschlusspunkt (E) umfasst, und
- einer zweiten Wicklungshälfte (10b), die einen zweiten elektrischen Anschlusspunkt (Vref1) umfasst,
wobei sich der erste und der zweite Anschlusspunkt im Wesentlichen in der Mitte der ersten Seite (53) befinden.

12. Stromtransformator nach einem der vorhergehenden Ansprüche, **dadurch gekennzeichnet, dass** er eine dritte Wicklung (110) und eine vierte Wicklung (120) aufweist, die mittels einer zweiten Leiterplatte (150) von im Wesentlichen quaderförmiger Gestalt ausgebildet sind, die eine zweite obere Fläche (151), eine zweite untere Fläche (152), eine fünfte Seite (153), eine sechste Seite (154), wobei die sechste Seite (154) der fünften Seite (153) gegenüberliegt, eine siebente Seite (155), eine achte Seite (156), wobei die achte Seite (156) der siebenten Seite (155) gegenüberliegt, aufweist, wobei die dritte und die vierte Wicklung (110, 120) jeweils gemäß einer Achse gewickelt sind, die zu der ersten bzw. zu der zweiten Wickelachse (X1, X2) parallel ist, wobei die zweite Leiterplatte (150) eine zweite Öffnung (157) in den zwei zweiten Flächen (151, 152) aufweist, um einen Durchgang für den elektrischen Leiter zu bilden, wobei die dritte Wicklung (110) und die vierte Wicklung (120) beiderseits der zweiten Öffnung (157) angeordnet sind,

13. Stromtransformator nach dem vorhergehenden Anspruch, **dadurch gekennzeichnet, dass** die zweite Leiterplatte (150) aufweist:
- ein drittes Positionierungsmittel (158), das dafür ausgelegt ist, mit dem ersten Haltemittel (31) zusammengebaut zu werden, um die erste Referenzfläche (32) in einem vorbestimmten Abstand von der siebenten Seite (155) zu halten, und
- ein viertes Positionierungsmittel (159), das dafür ausgelegt ist, mit dem zweiten Haltemittel (41) zusammengebaut zu werden, um die zweite Referenzfläche (42) in einem vorbestimmten Abstand von der achten Seite (156) zu halten.

14. Stromtransformator nach einem der Ansprüche 12 oder 13, **dadurch gekennzeichnet, dass**, wenn die dritte Wicklung (110) und die vierte Wicklung (120) von Windungen gebildet werden, die in der Dicke der zweiten Leiterplatte (150) ausgebildet sind:
- die dritte Wicklung (110) in einer Richtung gewickelt ist, die zur Wickelrichtung der ersten Wicklung (10) entgegengesetzt ist, und
- die vierte Wicklung (120) in einer Richtung gewickelt ist, die zur Wickelrichtung der zweiten Wicklung (20) entgegengesetzt ist.

15. Stromtransformator nach einem der Ansprüche 12 bis 14, **dadurch gekennzeichnet, dass** die dritte Wicklung (110) aufweist:
- eine dritte Wicklungshälfte (110a), die einen dritten elektrischen Anschlusspunkt (S) umfasst, und
- eine vierte Wicklungshälfte (110b), die einen vierten elektrischen Anschlusspunkt (Vref2) umfasst,
wobei sich der dritte elektrische Anschlusspunkt (S) und der vierte elektrische Anschlusspunkt (Vref2) im Wesentlichen in der Mitte der fünften Seite (153) befinden.

16. Stromtransformator nach einem der Ansprüche 12 bis 15, **dadurch gekennzeichnet, dass** die erste Leiterplatte (50) oder die zweite Leiterplatte (150) einen dritten Vorsprung (50c) aufweist, um zu installieren:
- Messschaltungen zum Verarbeiten von Signalen, die von der ersten, zweiten, dritten und vierten Wicklung (10, 20, 110, 120) geliefert werden, und Liefern eines Messsignals (M), das für den in der Stromleitung (2) fließenden Strom repräsentativ ist,
- elektrische Anschlüsse zum Übertragen des Messsignals (M) an ein Messgerät (5).

17. Messgerät (5) für den in einer Stromleitung (2) einer elektrischen Anlage fließenden Strom, **dadurch gekennzeichnet, dass** es aufweist:
- einen Stromtransformator (1) nach einem der Ansprüche 1 bis 16, welcher eine erste Öffnung (57) und eine zweite Öffnung (157) aufweist, durch die eine Stromleitung (2) hindurchführt, wobei der Stromtransformator (1) liefert:
- ein erstes Messsignal (M1), das für den Strom repräsentativ ist, der in der Stromleitung (2) fließt, die durch die erste Öffnung (57) hindurchführt, und
- ein zweites Messsignal (M2), das für den Strom repräsentativ ist, der in der Stromleitung (2) fließt, die durch die zweite Öffnung (157) der Strommessvorrichtung (1) hindurchführt, und
- eine Messschaltung (51), die mit dem Stromtransformator (1) verbunden ist, um das erste Messsignal (M1) und das zweite Messsignal (M2) zu empfangen, wobei die Messschaltung (51) einen Messwert (M) der Amplitude des Stroms liefert, der in der Stromleitung (2) fließt, wobei der Messwert (M) von einer Messung des ersten Messsignals (M1) und des zweiten Messsignals (M2) stammt,
- eine Schnittstellenschaltung (52), die mit der Messschaltung (51) verbunden ist, um den Messwert (M) des Messsignals anzuzeigen oder den Messwert zu übertragen, und
- eine Speiseschaltung (53) zum Versorgen der Messschaltung (51) und der Schnittstellenschaltung (52).

## Claims

1. Current transformer (1) comprising:
- a first coil (10) and a second coil (20), said coils being formed by means of a first printed circuit board (50) of substantially parallelepipedal shape, said printed circuit board comprising a first upper face (51), a first lower face (52), a first side (53), a second side (54), the second side (54) being opposite to the first side (53), a third side (55) and a fourth side (56), the fourth side (56) being opposite to the third side (55), the first coil (10) being formed from first turns (11, 13, 14) coiled about a first coiling axis (X1) that is substantially perpendicular to the third and fourth sides (55, 56), the second coil (20) being formed from second turns (21, 23, 24) coiled about a second coiling axis (X2) that is substantially perpendicular to the third and fourth sides (55, 56), the first printed circuit board (50) comprising a first aperture (57) in the first upper and lower faces (51, 52) so as to form a through-passage for a current line (2), said current line forming a primary circuit of the current transformer, the first coil and the second coil (10, 20) being placed on either side of the first aperture (57) and forming a secondary circuit, and
- a first magnetic part (30) of elongate shape comprising a first reference face (32) and at least one second magnetic part (40) of elongate shape comprising a second reference face (42),
the current transformer (1) being **characterized in that**:
- the first printed circuit board (50) comprising a first positioning means (58), placed in proximity to the third side (55), and a second positioning means (59) placed in proximity to the fourth side (56),
- the first magnetic part (30) comprising a first maintaining means (31),
- the second magnetic part (40) comprising a second maintaining means (41),
the first positioning means (58) is arranged to be assembled with the first maintaining means (31) to keep the first reference face (32) at a preset distance facing the third side (55), and the second positioning means (59) is arranged to be assembled with the second maintaining means (41) to keep the second reference face (42) at a preset distance facing the fifth side (56).

2. Current transformer according to Claim 1, **characterized in that**:
- the first positioning means (58) and the second positioning means (59) are holes drilled in the first printed circuit board (50),
- the first maintaining means (31) is a pin arranged to be inserted into the first positioning means (58), and
- the second maintaining means (41) is a pin arranged to be inserted into the second positioning means (59).

3. Current transformer according to the preceding claim, **characterized in that**:
- the first positioning means (58) is placed in a first protuberance (50a) formed on the third side (55) of the first printed circuit board (50),
- the second positioning means (59) is placed in a second protuberance (50b) formed on the fourth side (56) of said first printed circuit board (50),
- the first maintaining means (31) is formed by a notch in the first magnetic part (30), and
- the second maintaining means (41) is formed by a notch in the second magnetic part (40).

4. Current transformer according to any one of the preceding claims, **characterized in that** the first coil (10) and the second coil (20) are formed from turns coiled with a constant coiling pitch (P).

5. Current transformer according to the preceding claim, **characterized in that** the coiling pitch (P) is comprised between 50 and 700 microns.

6. Current transformer according to either of Claims 4 and 5, **characterized in that** the first reference face (32) and the second reference face (42) protrude past the first upper face (51) and the first lower face (52) by a distance larger than a coiling pitch (P).

7. Current transformer according to any one of Claims 4 to 6, **characterized in that** each turn being formed in the thickness of the first printed circuit board (50) and comprising a first conductive segment on the first upper face (51) of the first printed circuit board (50) and a second conductive segment on the first lower face (52) of said first printed circuit board (50), the first conductive segments of the turns of the first coil (10) are symmetric, with respect to the centre (57a) of the first aperture (57), with first conductive segments of the turns of the second coil (20) and the second conductive segments of the turns of the first coil (10) are symmetric, with respect to the centre (57a) of the first aperture (57), with second conductive segments of the turns of the second coil (20).

8. Current transformer according to any one of Claims 4 to 7, **characterized in that**, the first coil (10) comprising a first lateral turn (11) at a first end facing the first reference face (32), and a second lateral turn (14) at a second end facing the second reference face (42), and the second coil (20) comprising a third lateral turn (21) at a third end facing the first reference face (32), and a fourth lateral turn (24) at a fourth end facing the second reference face (42), the first coil (10) and the second coil (20) are placed on the first printed circuit board (50) in such a way that:
- the distance between the first lateral turn (11) of the first coil (10) and the first reference face (32) is substantially equal to half the coiling pitch (P),
- the distance between the first lateral turn (21) of the second coil (20) and the first reference face (32) is substantially equal to half the coiling pitch (P),
- the distance between the second lateral turn (14) of the first coil (10) and the second reference face (42) is substantially equal to half the coiling pitch (P), and
- the distance between the second lateral turn (24) of the second coil (20) and the second reference face (42) is substantially equal to half the coiling pitch (P).

9. Current transformer according to the preceding claim, **characterized in that** the ends of at least one of the first or second segments (11a, 11b, 14a, 14b, 21a, 21b, 24a, 24b) of the first lateral turn (11, 21) and of the second lateral turn (14, 24) of the first coil (10) and of the second coil (20), respectively, are curved to form a C the ends of which are directed away from the first reference face (32) and from the second reference face (42), respectively.

10. Current transformer according to either of Claims 8 and 9, **characterized in that** the first and second coils (10, 20) are electrically connected in series, the first lateral turn (11) of the first coil (10) being connected to the first lateral turn (21) of the second coil (20) and the second lateral turn (14) of the first coil being connected to the second lateral turn (24) of the second coil.

11. Current transformer according to the preceding claim, **characterized in that** the first coil (10) is composed of:
- a first half-coil (10a) comprising a first electrical connection point (E), and
- a second half-coil (10b) comprising a second electrical connection point (Vref1),
the first and second connection points being located substantially in the middle of the first side (53).

12. Current transformer according to any one of the preceding claims, **characterized in that** it comprises a third coil (110) and a fourth coil (120) that are formed by means of a second printed circuit board (150) of substantially parallelepipedal shape, said printed circuit board comprising a second upper face (151), a second lower face (152), a fifth side (153), a sixth side (154), the sixth side (154) being opposite to the fifth side (153), a seventh side (155) and an eighth side (156), the eighth side (156) being opposite to the seventh side (155), the third and fourth coils (110, 120) being coiled about axes that are parallel to the first and second coiling axes (X1, X2), respectively, the second printed circuit board (150) comprising a second aperture (157) in the two second faces (151, 152) so as to form a through-passage for the electrical conductor, the third coil (110) and the fourth coil (120) being placed on either side of the second aperture (157).

13. Current transformer according to the preceding claim, **characterized in that** the second printed circuit board (150) comprises:
- a third positioning means (158) arranged to be assembled with the first maintaining means (31) to keep the first reference face (32) at a preset distance from the seventh side (155), and
- a fourth positioning means (159) arranged to be assembled with the second maintaining means (41) to keep the second reference face (42) at a preset distance from the eighth side (156).

14. Current transformer according to either of Claims 12 and 13, **characterized in that**, the third coil (110) and the fourth coil (120) being formed from turns produced in the thickness of the second printed circuit board (150):
- the third coil (110) is coiled in an opposite direction with respect to the coiling direction of the first coil (10), and
- the fourth coil (120) is coiled in an opposite direction with respect to the coiling direction of the second coil (20).

15. Current transformer according to any one of Claims 12 to 14, **characterized in that** the third coil (110) comprises:
- a third half-coil (110a) comprising a third electrical connection point (S), and
- a fourth half-coil (110b) comprising a fourth electrical connection point (Vref2),
the third electrical connection point (S) and the fourth electrical connection point (Vref2) being located substantially in the middle of the fifth side (153).

16. Current transformer according to any one of Claims 12 to 15, **characterized in that** the first printed circuit board (50) or the second printed circuit board (150) comprises a third protuberance (50c) for the installation of:
- measurement circuits for processing signals delivered by the first, second, third and fourth coils (10, 20, 110, 120) and delivering a measurement signal (M) representative of the current flowing through the current line (2),
- electrical connections for transmitting the measurement signal (M) to a measuring apparatus (5).

17. Apparatus (5) for measuring the current flowing through a current line (2) of an electrical installation, **characterized in that** it comprises:
- a current transformer (1) according to one of Claims 1 to 16, comprising a first aperture (57) and a second aperture (157), through which apertures passes a current line (2), said current transformer (1) delivering:
- a first measurement signal (M1) representative of the current flowing through the current line (2) passing through the first aperture (57), and
- a second measurement signal (M2) representative of the current flowing through the current line (2) passing through the second aperture (157) of the device (1) for measuring current, and
- a measurement circuit (51), which is connected to the current transformer (1) with a view to receiving the first measurement signal (M1) and the second measurement signal (M2), said measurement circuit (51) delivering a measurement (M) of the amplitude of the current flowing through the current line (2), said measurement (M) resulting from a measurement of the first measurement signal (M1) and of the second measurement signal (M2),
- an interface circuit (52) connected to the measurement circuit (51) with a view to displaying the measurement (M) of the measurement signal or transmitting said measurement, and
- a power-supply circuit (53) for supplying the measurement circuit (51) and the interface circuit (52) with power.
